# EUROPEAN PATENT SPECIFICATION

(11) **EP 3 852 134 B1**
(45) Date of publication and mention of the grant of the patent: **05.11.2025**
(21) Application number: 18933150.7
(22) Date of filing: 11.09.2018
(51) Int. Cl.: H01L 23/00, C09J 5/06, C09J 175/04, C09J 163/00, C09J 133/06, C08G 59/42, C08G 18/72, C08G 18/62, C08F 220/18, C08F 220/06, H01L 21/683, H01L 21/56, C09J 7/38, C09J 7/20

(54) **PRESSURE SENSITIVE ADHESIVE FILM AND METHOD FOR MANUFACTURING ELECTRONIC DEVICE**
HAFTKLEBEFILM UND VERFAHREN ZUR HERSTELLUNG EINER ELEKTRONISCHEN VORRICHTUNG
FILM AUTOCOLLANT ET PROCÉDÉ DE FABRICATION D'UN DISPOSITIF ÉLECTRONIQUE

(43) Date of publication of application: 21.07.2021
(73) Proprietor: Mitsui Chemicals ICT Materia, Inc., Tokyo 104-0028 (JP)
(72) Inventor: KURIHARA, Hiroyoshi, Nagoya-shi, Aichi 457-0801 (JP); IGARASHI, Kouji, 40211 Duesseldorf (DE)
(74) Representative: Hoffmann Eitle
(86) International application number: PCT/JP2018/033579
(87) International publication number: WO 2020/053949

(56) References cited:
- EP-A1- 2 666 834
- EP-A1- 2 666 835
- EP-A1- 3 572 478
- WO-A1-2015/029871
- WO-A1-2016/199819
- WO-A1-2017/038917
- WO-A1-2018/135546
- WO-A1-2018/135546
- JP-A- 2012 062 372
- JP-A- 2013 191 592
- US-A1- 2010 119 757
- US-A1- 2018 151 393

## Description

### TECHNICAL FIELD

The present invention relates to the use of a pressure sensitive adhesive film and a method for manufacturing an electronic device.

### BACKGROUND ART

As a technology which is able to reduce the size and weight of electronic devices (for example, semiconductor apparatuses), a fan-out type WLP (wafer level package) is being developed.

In an eWLB (Embedded Wafer Level Ball Grid Array), which is one of the methods for manufacturing a fan-out type WLP, it is possible to adopt a method in which a plurality of electronic components such as semiconductor chips are temporarily fixed in a separated state on a pressure sensitive adhesive film attached to a support substrate, and the plurality of electronic components are sealed in a batch with a sealing material. Here, the pressure sensitive adhesive film needs to be fixed to the electronic component and the support substrate in the sealing step or the like and needs to be removed from the sealed electronic component and the support substrate after the sealing.

Examples of a technique related to such a fan-out type WLP manufacturing method include the technique described in Patent Document 1 (Japanese Unexamined Patent Application Publication No. 2011-134811).

Furthermore, EP 2 666 834 A1, EP 2 666 835 A1 and US 2010/119757 A1 are concerned with double-sided pressure-sensitive adhesive sheets, which are used for ceramic capacitor manufacturing processes. The adhesive sheets may comprise a pressure-sensitive adhesive layer, a heat-expandable pressure-sensitive adhesive layer and further a base material and a rubber-like organic elastic layer, which are arranged between the adhesive layers.

In WO 2018/135546 A1, an adhesive film for temporarily fixing an electronic component when sealing the electronic component with a sealing material is described. The adhesive film comprises an adhesive resin layer (A), which contains a polyvalent carboxylic acid ester-based plasticizer, and a releasable adhesive resin layer (B), which are arranged on opposite sides of a base material.

Patent Document 1 discloses a heat-resistant pressure sensitive adhesive sheet for manufacturing a semiconductor apparatus, which is used by being attached when resin-sealing a substrateless semiconductor chip, in which the heat-resistant pressure sensitive adhesive sheet has a base material layer and a pressure sensitive adhesive layer, and the pressure sensitive adhesive layer has an adhesive force to SUS304 after bonding of 0.5 N/20 mm or more, is cured by a stimulus received until the completion of a resin sealing step, and has a peel force with respect to a package of 2.0 N/20 mm or less.

### RELATED DOCUMENT

### PATENT DOCUMENT

[Patent Document 1] Japanese Unexamined Patent Application Publication No. 2011-134811

### SUMMARY OF THE INVENTION

### TECHNICAL PROBLEM

According to studies by the inventors of the present invention, it was clear that, when an electronic component is arranged on a pressure sensitive adhesive film attached to a support substrate, the electronic component is sealed with a sealing material, and then the pressure sensitive adhesive film is peeled from the support substrate, a part (also referred to below as glue) of the pressure sensitive adhesive resin layer of the pressure sensitive adhesive film may remain on the support substrate side (also referred to below as glue residue).

The present invention is made in consideration of the above circumstances and provides the use of a pressure sensitive adhesive film for temporarily fixing electronic components, which is able to suppress glue residue on a support substrate side when peeling the pressure sensitive adhesive film from a support substrate.

### SOLUTION TO PROBLEM

The inventors of the present invention carried out intensive studies in order to achieve the above object. As a result, it was found that, by providing an intermediate layer (C) having a specific elastic modulus and loss tangent (tan δ) between a pressure sensitive adhesive resin layer (A) for temporarily fixing electronic components and a pressure sensitive adhesive resin layer (B), of which an adhesive force is decreased by heating or radiation as an external stimulus, it is possible to suppress glue residue on the support substrate side when the pressure sensitive adhesive film is peeled from the support substrate, thereby completing the present invention.

According to the present invention, the use of a pressure sensitive adhesive film and a method for manufacturing an electronic device are provided as defined in the appended claims.

The present invention relates to the use of a pressure sensitive adhesive film for temporarily fixing electronic components when sealing the electronic components with a sealing material in an electronic device manufacturing step, the film including a pressure sensitive adhesive resin layer (A) used for temporarily fixing the electronic components, a pressure sensitive adhesive resin layer (B) used for attaching to a support substrate and of which an adhesive force is decreased by heating or radiation as an external stimulus, and an intermediate layer (C) provided between the pressure sensitive adhesive resin layer (A) and the pressure sensitive adhesive resin layer (B). A storage elastic modulus E' at 120°C of the intermediate layer (C) is 1.0 x 10⁵ Pa or more and 8.0 x 10⁶ Pa or less and a loss tangent (tan δ) at 120°C of the intermediate layer (C) is 0.1 or less. The intermediate layer (C) includes a (meth)acrylic resin and a cross-linking agent having two or more cross-linkable functional groups in one molecule, and the content of the cross-linking agent in the intermediate layer (C) is 0.7 parts by mass or more and 10 parts by mass or less with respect to 100 parts by mass of the (meth)acrylic resin.

The present invention further relates to a method for manufacturing an electronic device including at least a step (1) of preparing a structure having the pressure sensitive adhesive film, an electronic component attached to the pressure sensitive adhesive resin layer (A) of the pressure sensitive adhesive film, and a support substrate attached to the pressure sensitive adhesive resin layer (B) of the pressure sensitive adhesive film; a step (2) of sealing the electronic component with a sealing material; a step (3) of peeling the support substrate from the structure by decreasing an adhesive force of the pressure sensitive adhesive resin layer (B) by applying the external stimulus; and a step (4) of peeling the pressure sensitive adhesive film from the electronic component.

The sealing material is preferably an epoxy resin-based sealing material.

### ADVANTAGEOUS EFFECTS OF INVENTION

The pressure sensitive adhesive film for temporarily fixing electronic components as used according to the present invention is able to suppress glue residue on the support substrate side when a pressure sensitive adhesive film is peeled from a support substrate.

### BRIEF DESCRIPTION OF THE DRAWINGS

The objective described above and other objectives, features, and advantages will be further clarified by suitable embodiments described below and the accompanying drawings below.
Fig. 1 is a cross-sectional view schematically showing an example of a structure of a pressure sensitive adhesive film of an embodiment as used according to the present invention.
Fig. 2 is a cross-sectional view schematically showing an example of a structure of a pressure sensitive adhesive film of an embodiment as used according to the present invention.
Fig. 3 is a cross-sectional view schematically showing an example of a method for manufacturing an electronic device of an embodiment according to the present invention.
Fig. 4 is a cross-sectional view schematically showing an example of a method for manufacturing an electronic device of an embodiment according to the present invention.

### DESCRIPTION OF EMBODIMENTS

A description will be given below of embodiments with reference to the drawings. In all the drawings, common reference numerals are given to the same constituent components and description thereof will not be provided as appropriate. In addition, the figures are schematic views and do not match the actual dimensional ratios. In addition, unless otherwise specified, "A to B" in the numerical range represents A or more and B or less. In addition, in the present embodiment, "(meth)acrylic" means acrylic, methacrylic, or both acrylic and methacrylic.

### 1. Pressure Sensitive Adhesive Film for Temporarily Fixing Electronic Components

A description will be given below of a pressure sensitive adhesive film 50 according to the present embodiment.

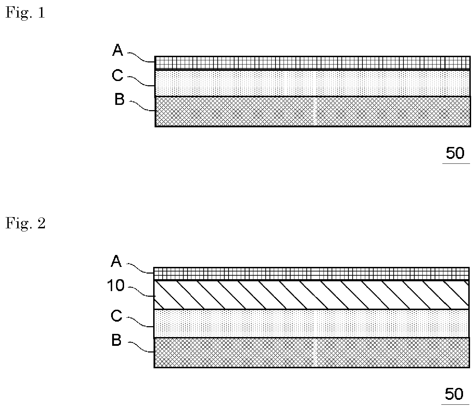

Fig. 1 and Fig. 2 are cross-sectional views schematically showing examples of the structure of the pressure sensitive adhesive film 50 of the embodiment as used according to the present invention.

As shown in Fig. 1, the pressure sensitive adhesive film 50 according to the present embodiment is a pressure sensitive adhesive film used to temporarily fix electronic components when sealing the electronic components with a sealing material in an electronic device manufacturing step, the film being provided with a pressure sensitive adhesive resin layer (A) for temporarily fixing the electronic components, a pressure sensitive adhesive resin layer (B) used for attaching to a support substrate and of which an adhesive force is decreased by an external stimulus, and an intermediate layer (C) provided between the pressure sensitive adhesive resin layer (A) and the pressure sensitive adhesive resin layer (B). Here, a storage elastic modulus E' at 120°C of the intermediate layer (C) is 1.0 x 10⁵ Pa or more and 8.0 x 10⁶ Pa or less and a loss tangent (tan δ) at 120°C of the intermediate layer (C) is 0.1 or less.

As described above, according to studies by the inventors of the present invention, it was clear that, when an electronic component is arranged on a pressure sensitive adhesive film attached to a support substrate, the electronic component is sealed with a sealing material, and then the pressure sensitive adhesive film is peeled from the support substrate, glue residue may be generated on the support substrate side.

The reason for this is not clear, but the following reasons may be considered. First, when the electronic component is sealed with the sealing material, a metal frame (an outer periphery of the mold) comes into contact with the pressure sensitive adhesive film and stress is applied to the pressure sensitive adhesive film and the support substrate at the contact site. At the site where this stress is applied, the adhesive force between the support substrate and the pressure sensitive adhesive resin layer increases, and when the pressure sensitive adhesive film is peeled from the support substrate, it is thought that a phenomenon occurs in which a part of the pressure sensitive adhesive resin layer of the pressure sensitive adhesive film remains on the support substrate side.

The inventors of the present invention carried out intensive studies to realize a pressure sensitive adhesive film for temporarily fixing electronic components which is able to suppress glue residue on the support substrate side when sealing electronic components with a sealing material in an electronic device manufacturing step. As a result, it was found that, in a pressure sensitive adhesive film provided with a pressure sensitive adhesive resin layer (A) for temporarily fixing the electronic components and a pressure sensitive adhesive resin layer (B) of which an adhesive force is decreased by an external stimulus, it is effective to provide an intermediate layer (C) having a specific elastic modulus and loss tangent (tan δ) between the pressure sensitive adhesive resin layer (A) and the pressure sensitive adhesive resin layer (B).

Then, the inventors of the present invention carried out further studies based on the above findings and as a result found, for the first time, that setting the storage elastic modulus E' and loss tangent (tan δ) at 120°C of the intermediate layer (C) in the ranges described above makes it possible to effectively suppress the glue residue on the support substrate side when the pressure sensitive adhesive film is peeled from the support substrate.

That is, in the pressure sensitive adhesive film 50 according to the present embodiment, an intermediate layer (C) is provided between the pressure sensitive adhesive resin layer (A) and the pressure sensitive adhesive resin layer (B) and, by setting the storage elastic modulus E' and loss tangent (tan δ) at 120°C of the intermediate layer (C) in the ranges described above, it is possible to effectively suppress the glue residue on the support substrate side when the pressure sensitive adhesive film is peeled from the support substrate.

The reason why using the pressure sensitive adhesive film 50 according to the present embodiment makes it possible to effectively suppress the glue residue on the support substrate side when the pressure sensitive adhesive film is peeled from the support substrate is not clear, but the following reasons may be considered.

First, as described above, when the electronic component is sealed with the sealing material, a metal frame (an outer periphery of the mold) comes into contact with the pressure sensitive adhesive film and stress is applied to the pressure sensitive adhesive film and the support substrate at the contact site. At the site where this stress is applied, the adhesive force between the support substrate and the pressure sensitive adhesive resin layer increases, and when the pressure sensitive adhesive film is peeled from the support substrate, it is thought that a phenomenon occurs in which a part of the pressure sensitive adhesive resin layer of the pressure sensitive adhesive film remains on the support substrate side.

On the other hand, in the pressure sensitive adhesive film 50 according to the present embodiment, the intermediate layer (C) having a storage elastic modulus E' and a loss tangent (tan δ) at 120°C within the range described above is provided between the pressure sensitive adhesive resin layer (A) and the pressure sensitive adhesive resin layer (B). It is considered that this intermediate layer (C) alleviates the stress from the metal frame and is able to suppress an increase in adhesive force between the support substrate and the pressure sensitive adhesive resin layer and, as a result, is able to effectively suppress the glue residue on the support substrate side when the pressure sensitive adhesive film is peeled from the support substrate.

From the viewpoint of the balance between mechanical properties and handleability, the total thickness of the pressure sensitive adhesive film 50 according to the present embodiment is preferably 10 µm or more and 1000 µm or less, and more preferably 20 µm or more and 500 µm or less.

It is possible to use the pressure sensitive adhesive film 50 according to the present embodiment in a film for temporarily fixing electronic components in an electronic device manufacturing step, and particularly, suitable use is possible as a film for temporarily fixing electronic components in a manufacturing step for a fan-out type WLP or a fan-out type PLP.

Next, a description will be given of each layer forming the pressure sensitive adhesive film 50 according to the present embodiment.

### <Pressure Sensitive Adhesive Resin Layer (A)>

The pressure sensitive adhesive resin layer (A) is a layer for contacting the surface of the electronic component to temporarily fix the electronic component when the electronic component is sealed with a sealing material in the electronic device manufacturing step.

The pressure sensitive adhesive resin layer (A) includes a pressure sensitive adhesive resin.

Examples of the pressure sensitive adhesive resin include a (meth)acrylic pressure sensitive adhesive resin, a silicone-based pressure sensitive adhesive resin, a urethane-based pressure sensitive adhesive resin, an olefin-based pressure sensitive adhesive resin, and a styrene-based pressure sensitive adhesive resin.

Among the above, the (meth) acrylic pressure sensitive adhesive resin is preferable from the viewpoint of facilitating the adjustment of the adhesive force.

As the pressure sensitive adhesive resin layer (A), it is also possible to use a radiation cross-linking pressure sensitive adhesive resin layer of which the adhesive force is decreased by radiation. The radiation cross-linking pressure sensitive adhesive resin layer is cross-linked by the irradiation of radiation and the adhesive force is significantly reduced, thus, the pressure sensitive adhesive film 50 is easily peeled from the electronic component. Examples of the radiation include ultraviolet rays, electron beams, and infrared rays.

As the radiation cross-linking pressure sensitive adhesive resin layer, an ultraviolet cross-linking pressure sensitive adhesive resin layer is preferable.

Examples of the (meth) acrylic pressure sensitive adhesive resin used in the pressure sensitive adhesive resin layer (A) include a copolymer including a (meth)acrylic acid alkyl ester monomer unit (A) and a monomer unit (B) having a functional group capable of reacting with a cross-linking agent.

In the present embodiment, the (meth)acrylic acid alkyl ester means an acrylic acid alkyl ester, a methacrylic acid alkyl ester, or a mixture thereof.

It is possible to obtain the (meth)acrylic pressure sensitive adhesive resin according to the present embodiment, for example, by copolymerizing a monomer mixture including a (meth) acrylic acid alkyl ester monomer (A) and a monomer (B) having a functional group capable of reacting with a cross-linking agent.

Examples of the monomer (A) forming the (meth) acrylic acid alkyl ester monomer unit (A) include a (meth) acrylic acid alkyl ester having an alkyl group having approximately 1 to 12 carbon atoms. A (meth)acrylic acid alkyl ester having an alkyl group having 1 to 8 carbon atoms is preferable. Specific examples thereof include methyl acrylate, methyl methacrylate, ethyl acrylate, ethyl methacrylate, butyl acrylate, butyl methacrylate, 2-ethylhexyl acrylate, and 2-ethylhexyl methacrylate. These may be used alone or in a combination of two or more types. In the (meth) acrylic pressure sensitive adhesive resin according to the present embodiment, when the total of all the monomer units in the (meth)acrylic pressure sensitive adhesive resin is 100% by mass, the content of the (meth)acrylic acid alkyl ester monomer unit (A) is preferably 10% by mass or more and 98.9% by mass or less, and more preferably 85% by mass or more and 95% by mass or less.

Examples of the monomer (B) forming the monomer (B) having a functional group capable of reacting with the cross-linking agent include acrylic acid, methacrylic acid, itaconic acid, mesaconic acid, citraconic acid, fumaric acid, maleic acid, itaconic acid monoalkyl ester, mesaconic acid monoalkyl ester, citraconic acid monoalkyl ester, fumaric acid monoalkyl ester, maleic acid monoalkyl ester, glycidyl acrylate, glycidyl methacrylate, 2-hydroxyethyl acrylate, 2-hydroxyethyl methacrylate, acrylamide, methacrylamide, tert-butylaminoethyl acrylate, and tert-butylaminoethyl methacrylate. Preferable are acrylic acid, methacrylic acid, 2-hydroxyethyl acrylate, 2-hydroxyethyl methacrylate, acrylamide, and methacrylamide. These may be used alone or in a combination of two or more types.

In the (meth)acrylic pressure sensitive adhesive resin according to the present embodiment, when the total of all the monomer units in the (meth) acrylic pressure sensitive adhesive resin is 100% by mass, the content of the monomer unit (B) is preferably 1% by mass or more and 40% by mass or less, more preferably 1% by mass or more and 20% by mass or less, and even more preferably 1% by mass or more and 10% by mass or less.

The (meth)acrylic pressure sensitive adhesive resin according to the present embodiment may, in addition to the monomer unit (A) and the monomer unit (B), further include a bifunctional monomer (C) and a specific comonomer (referred to below as a polymerizable surfactant) unit having properties as a surfactant.

The polymerizable surfactant has a property of copolymerizing with the monomer (A), the monomer (B), and the monomer (C), and also has an action as an emulsifier in the case of emulsion polymerization.

Examples of the monomer (C) forming the bifunctional monomer unit (C) include allyl methacrylate, allyl acrylate, divinylbenzene, vinyl methacrylate, vinyl acrylate, trimethylolpropane tri(meth)acrylate, pentaerythritol tri(meth)acrylate, dipentaerythritol hexa(meth)acrylate, tetraethylene glycol di(meth)acrylate, or, for example, monomers in which a main chain structure is a propylene glycol type with diacrylate or dimethacrylate at both ends (for example, manufactured by NOF Corp., trade name: PDP-200, PDP-400, ADP-200, and ADP-400), tetramethylene glycol type monomers (for example, manufactured by NOF Corp., trade name: ADT-250, ADT-850), and mixtures thereof (for example, manufactured by NOF Corp., trade name: ADET-1800 and ADPT-4000).

In the (meth)acrylic pressure sensitive adhesive resin according to the present embodiment, when the total of all the monomer units in the (meth) acrylic pressure sensitive adhesive resin is 100% by mass, the content of the monomer unit (C) is preferably 0.1% by mass or more and 30% by mass or less, and more preferably 0.1% by mass or more and 5% by mass or less.

Examples of the polymerizable surfactant include a surfactant in which a polymerizable 1-propenyl group is introduced into a benzene ring of polyoxyethylene nonylphenyl ether (manufactured by Daiichi Kogyo Seiyaku Co., Ltd.; trade name: Aqualon RN-10, RN-20, RN-30, and RN-50), a surfactant in which a polymerizable 1-propenyl group is introduced into a benzene ring of ammonium salt of sulfuric acid ester of polyoxyethylene nonylphenyl ether (manufactured by Daiichi Kogyo Seiyaku Co., Ltd.; trade name: Aqualon HS-10, HS-20, and HS-1025), and a sulfosuccinate diester-based surfactant having a polymerizable double bond in the molecule (manufactured by Kao Corp. ; trade name: Latemul S-120A and S-180A).

The (meth)acrylic pressure sensitive adhesive resin according to the present embodiment may further include a monomer unit formed of a monomer having a polymerizable double bond such as vinyl acetate, acrylonitrile, or styrene, as necessary.

Examples of the polymerization reaction mechanism of the (meth)acrylic pressure sensitive adhesive resin according to the present embodiment include radical polymerization, anionic polymerization, and cationic polymerization. In consideration of the manufacturing cost of the (meth)acrylic pressure sensitive adhesive resin, the influence of the functional group of the monomer, and the influence of ions on the surface of the electronic component, it is preferable to carry out the polymerization by radical polymerization.

When polymerizing by a radical polymerization reaction, examples of radical polymerization initiators include organic peroxides such as benzoyl peroxide, di-t-butyl peroxide, dicumyl peroxide, 3,3,5-trimethylhexanoyl peroxide, di-2-ethylhexylperoxy dicarbonate, methyl ethyl ketone peroxide, t-butylperoxyphthalate, t-butylperoxybenzoate, di-t-butylperoxyacetate, t-butylperoxyisobutyrate, t-butylperoxy-2-hexanoate, t-butylperoxy-2-ethylhexanoate, t-butylperoxy-3,5,5-trimethylhexanoate, acetyl peroxide, isobutyryl peroxide, octanoyl peroxide, t-butyl peroxide, and di-t-amyl peroxide; inorganic peroxides such as ammonium persulfate, potassium persulfate, and sodium persulfate; azo compounds such as 2,2'-azobisisobutyronitrile, 2,2'-azobis-2-methylbutyronitrile, and 4,4'-azobis-4-cyanovaleric acid.

In a case of polymerizing by an emulsion polymerization method, among these radical polymerization initiators, inorganic peroxides such as water-soluble ammonium persulfate, potassium persulfate, and sodium persulfate, and azo compounds having a carboxyl group in the molecule such as water-soluble 4,4'-azobis-4-cyanovaleric acid are preferable. Considering the influence of ions on the surface of the electronic components, ammonium persulfate and azo compounds having a carboxyl group in the molecule such as 4,4'-azobis-4-cyanovaleric acid are more preferable, and azo compounds having a carboxyl group in the molecule such as 4,4'-azobis-4-cyanovaleric acid are particularly preferable.

The pressure sensitive adhesive resin layer (A) according to the present embodiment preferably further includes a cross-linking agent having two or more cross-linkable functional groups in one molecule, in addition to the (meth)acrylic pressure sensitive adhesive resin.

A cross-linking agent having two or more cross-linkable functional groups in one molecule is used to react with the functional group of the (meth)acrylic pressure sensitive adhesive resin and adjust the adhesive force and aggregating force.

Examples of such a cross-linking agent include epoxy-based compounds such as sorbitol polyglycidyl ether, polyglycerol polyglycidyl ether, pentaerythritol polyglycidyl ether, diglycerol polyglycidyl ether, glycerol polyglycidyl ether, neopentyl glycol diglycidyl ether, and resorcin diglycidyl ether; isocyanate-based compounds such as tetramethylene diisocyanate, hexamethylene diisocyanate, toluene diisocyanate 3 adducts of trimethylolpropane, polyisocyanate, diphenylmethane diisocyanate, and tolylene diisocyanate; aziridine-based compounds such as trimethylolpropane-tri-β-aziridinylpropionate, tetramethylolmethane-tri-β-aziridinylpropionate, N,N'-diphenylmethane-4,4'-bis(1-aziridinecarboxamide), N,N'-hexamethylene-1,6-bis(1-aziridinecarboxamide), N,N'-toluene-2,4-bis(1-aziridinecarboxamide), and trimethylolpropane-tri-β-(2-methylaziridine) propionate; tetrafunctional epoxy-based compounds such as N,N,N',N'-tetraglycidyl-m-xylenediamine and 1,3-bis(N,N'-diglycidylaminomethyl) cyclohexane; and melamine-based compounds such as hexamethoxymethylolmelamine. These may be used alone or in a combination of two or more types.

Among the above, it is preferable to include one type or two or more types selected from an epoxy-based compound (including the tetrafunctional epoxy-based compounds described above), an isocyanate-based compound, and an aziridine-based compound.

The content of the cross-linking agent is usually preferably in a range in which the number of functional groups in the cross-linking agent does not exceed the number of functional groups in the (meth)acrylic pressure sensitive adhesive resin. However, in a case where a functional group is newly generated in the cross-linking reaction or a case where the cross-linking reaction is slow, the content thereof may be greater as necessary. From the viewpoint of improving the balance between the heat resistance and the adhesive force of the pressure sensitive adhesive resin layer (A), the content of the cross-linking agent in the pressure sensitive adhesive resin layer (A) is preferably 0.1 parts by mass or more and 30 parts by mass or less with respect to 100 parts by mass of the (meth) acrylic pressure sensitive adhesive resin, more preferably 0.1 part by mass or more and 20 parts by mass or less, and even more preferably 0.1 part by mass or more and 15 parts by mass or less.

The thickness of the pressure sensitive adhesive resin layer (A) is not particularly limited, but is, for example, preferably 1 µm or more and 100 µm or less, and more preferably 3 µm or more and 50 µm or less.

It is possible to form the pressure sensitive adhesive resin layer (A), for example, by coating a pressure sensitive adhesive on the intermediate layer (C) or a base material layer 10 described below. The pressure sensitive adhesive may be dissolved in a solvent and coated as a coating solution, coated as an aqueous emulsion, or directly coated as a liquid pressure sensitive adhesive.

Examples of the aqueous emulsion coating solution include coating solutions in which the (meth)acrylic pressure sensitive adhesive resin (a), a silicone-based pressure sensitive adhesive resin, a urethane-based pressure sensitive adhesive resin, an olefin-based pressure sensitive adhesive resin, or a styrene-based pressure sensitive adhesive resin is dispersed in water. A pressure sensitive adhesive coating solution dissolved in an organic solvent may be used. The organic solvent is not particularly limited and may be appropriately selected from known organic solvents in consideration of solubility and drying time. Examples of organic solvents include ester-based organic solvents such as ethyl acetate and methyl acetate; ketone-based organic solvents such as acetone and MEK; aromatic-based organic solvents such as benzene, toluene, and ethylbenzene; linear or cyclic aliphatic-based organic solvents such as heptane, hexane, and cyclohexane; alcohol-based organic solvents such as isopropanol and butanol. Ethyl acetate and toluene are preferable as the organic solvent. These solvents may be used alone as one type or used in a mixture of two or more types. As a method for coating the pressure sensitive adhesive coating solution, it is possible to adopt a coating method known in the related art, for example, a roll coater method, a reverse roll coater method, a gravure roll method, a bar coating method, a comma coater method, or a die coater method. The drying conditions of the coated pressure sensitive adhesive are not particularly limited, but in general, it is preferable to perform the drying in a temperature range of 80°C to 200°C for 10 seconds to 10 minutes. More preferably, drying is performed at 80°C to 170°C for 15 seconds to 5 minutes. In order to sufficiently promote the cross-linking reaction between the cross-linking agent and the pressure sensitive adhesive, after the drying of the pressure sensitive adhesive coating solution is completed, heating may be carried out at 40°C to 80°C for approximately 5 to 300 hours.

In addition, the intermediate layer (C) or the base material layer 10 and the pressure sensitive adhesive resin layer (A) may be molded by coextrusion molding, or the film-like intermediate layer (C) or the base material layer 10 and the film-like pressure sensitive adhesive resin layer (A) may be molded by laminating.

### <Pressure Sensitive Adhesive Resin Layer (B) >

The pressure sensitive adhesive film 50 according to the present embodiment is provided with a pressure sensitive adhesive resin layer (B) used for attaching to a support substrate and of which the adhesive force is decreased by heating or radiation as an external stimulus.

Due to this, it is possible to easily peel the pressure sensitive adhesive film 50 from the support substrate by applying an external stimulus.

Here, the pressure sensitive adhesive resin layer (B), of which the adhesive force is decreased by an external stimulus, is a heat-peelable adhesive resin layer, of which the adhesive force is decreased by heating, or a radiation-peelable pressure sensitive adhesive resin layer, of which the adhesive force is decreased by radiation. Among the above, a heat-peelable pressure sensitive adhesive resin layer, of which the adhesive force is decreased by heating, is preferable.

Examples of the heat-peelable pressure sensitive adhesive resin layer include pressure sensitive adhesive resin layers formed of a heat-expandable pressure sensitive adhesive including a gas generating component, a heat-expandable pressure sensitive adhesive including heat-expandable microspheres capable of expanding to decrease the adhesive force, and a heat-expandable pressure sensitive adhesive, of which the adhesive force is decreased by the cross-linking reaction of the adhesive components by heat.

In the present embodiment, the heat-expandable pressure sensitive adhesive used in the pressure sensitive adhesive resin layer (B) is a pressure sensitive adhesive, the adhesive force of which is decreased or lost by the application of heat. For example, it is possible to select a material which does not peel at a temperature of 150°C or lower and which does peel at a temperature over 150°C and preferably has an adhesive force such that the pressure sensitive adhesive film 50 does not peel from the support substrate during the electronic device manufacturing step.

As the gas generating component used in the heat-expandable pressure sensitive adhesive, for example, it is possible to use an azo compound, an azide compound, or a Meldrum's acid derivative. In addition, it is also possible to use inorganic foaming agents such as ammonium carbonate, ammonium hydrogencarbonate, sodium hydrogencarbonate, ammonium nitrite, sodium borohydride, and various azides, or water; salts of fluoroalkane-based compounds such as trichloromonofluoromethane and dichloromonofluoromethane; azo-based compounds such as azobisisobutyronitrile, azodicarbonamide, and barium azodicarboxylate; hydrazine-based compounds such as paratoluenesulfonyl hydrazide, diphenylsulfone-3,3'-disulfonylhydrazide, 4,4'-oxybis(benzenesulfonyl hydrazide) and allylbis(sulfonylhydrazide); semicarbazide-based compounds such as p-toluylenesulfonyl semicarbazide, and 4,4'-oxybis(benzenesulfonyl semicarbazide); triazole-based compounds such as 5-morpholyl-1,2,3,4-thiatriazole; and organic foaming agents such as N-nitroso compounds such as N,N'-dinitrosopentamethylenetetramine, and N,N'-dimethyl-N,N'-dinitrosoterephthalamide. The gas generating component may be added to the pressure sensitive adhesive resin or may be directly bonded to the pressure sensitive adhesive resin.

As the heat-expandable microspheres used for the heat-expandable pressure sensitive adhesive, for example, it is possible to use a microencapsulated foaming agent. Examples of such heat-expandable microspheres include microspheres in which a substance that is easily gasified and expanded by heating such as isobutane, propane, and pentane is sealed in a shell having elasticity. Examples of the material forming the shell include vinylidene chloride-acrylonitrile copolymer, polyvinyl alcohol, polyvinyl butyral, polymethyl methacrylate, polyacrylonitrile, polyvinylidene chloride, and polysulfone. It is possible to manufacture heat-expandable microspheres by, for example, a coacervation method or an interfacial polymerization method.

It is possible to add heat-expandable microspheres to the pressure sensitive adhesive resin.

It is possible to appropriately set the content of at least one type selected from the gas generating component and the heat-expandable microspheres according to the expansion ratio and the decrease in adhesive force of the heat-peelable pressure sensitive adhesive resin layer (B) without being particularly limited; however, for example, with respect to 100 parts by mass of the pressure sensitive adhesive resin in the heat-peelable pressure sensitive adhesive resin layer (B), the content is, for instance, 1 part by mass or more and 150 parts by mass or less, preferably 5 parts by mass or more and 130 parts by mass or less, and more preferably 10 parts by mass or more and 100 parts by mass or less.

It is preferable to implement the design such that the temperature at which gas is generated or the temperature at which the heat-expandable microspheres heat-expand is over 150°C.

Examples of the pressure sensitive adhesive resin forming the heat-expandable pressure sensitive adhesive include a (meth) acrylic resin, a urethane-based resin, a silicone-based resin, a polyolefin-based resin, a polyester-based resin, a polyamide-based resin, a fluorine-based resin, and a styrene-diene block copolymer-based resin. Among these, the (meth)acrylic resin is preferable.

As the (meth)acrylic resin used for the pressure sensitive adhesive resin layer (B), for example, it is possible to use the same resin as the (meth)acrylic pressure sensitive adhesive resin used for the pressure sensitive adhesive resin layer (A) described above.

In addition, from the viewpoint of stably holding the electronic component on the pressure sensitive adhesive resin layer (A) when an external stimulus is applied so as to decrease the adhesive force of the pressure sensitive adhesive resin layer (B) and peel the support substrate from the pressure sensitive adhesive resin layer (B), in the pressure sensitive adhesive film 50 according to the present embodiment, when the total of the pressure sensitive adhesive resin layer (A) is 100% by mass, the content of at least one type selected from the gas generating component and the heat-expandable microspheres in the pressure sensitive adhesive resin layer (A) is preferably 0.1% by mass or less, more preferably 0.05% by mass or less, even more preferably 0.01% by mass or less, and particularly preferably such that at least one type selected from a gas generating component and heat-expandable microspheres is not included in the pressure sensitive adhesive resin layer (A).

The thickness of the pressure sensitive adhesive resin layer (B) is not particularly limited, but, for example, is preferably 5 µm or more and 300 µm or less, and more preferably 10 µm or more and 150 µm or less.

It is possible to form the pressure sensitive adhesive resin layer (B), for example, by coating a pressure sensitive adhesive coating solution on the intermediate layer (C) or the base material layer 10 described below. As a method for coating the pressure sensitive adhesive coating solution, it is possible to adopt a coating method known in the related art, for example, a roll coater method, a reverse roll coater method, a gravure roll method, a bar coating method, a comma coater method, or a die coater method. The drying conditions of the coated pressure sensitive adhesive are not particularly limited, but in general, it is preferable to perform the drying in a temperature range of 80°C to 200°C for 10 seconds to 10 minutes. More preferably, drying is performed at 80°C to 170°C for 15 seconds to 5 minutes. In order to sufficiently promote the cross-linking reaction between the cross-linking agent and the pressure sensitive adhesive, after the drying of the pressure sensitive adhesive coating solution is completed, heating may be carried out at 40°C to 80°C for approximately 5 to 300 hours.

In addition, the intermediate layer (C) or the base material layer 10 and the pressure sensitive adhesive resin layer (B) may be molded by coextrusion molding, or the film-like intermediate layer (C) or the base material layer 10 and the film-like pressure sensitive adhesive resin layer (B) may be molded by laminating.

### <Intermediate Layer (C)>

The pressure sensitive adhesive film 50 according to the present embodiment is provided with the intermediate layer (C) having a specific elastic modulus and loss tangent (tan δ) between the pressure sensitive adhesive resin layer (A) and the pressure sensitive adhesive resin layer (B). Due to this, the stress absorption of the entire pressure sensitive adhesive film 50 is improved and it is possible to alleviate the stress from the metal frame when sealing the electronic component with the sealing material, and as a result, it is possible to suppress an increase in the adhesive force between the support substrate and the pressure sensitive adhesive resin layer (B), and as a result, it is possible to effectively suppress the glue residue on the support substrate side when the pressure sensitive adhesive film 50 is peeled from the support substrate.

In the pressure sensitive adhesive film 50 according to the present embodiment, from the viewpoint of effectively suppressing glue residue on the support substrate side when the pressure sensitive adhesive film 50 is peeled from the support substrate, the storage elastic modulus E' at 120°C of the intermediate layer (C) is 1.0×10⁵ Pa or more, preferably 1.5×10⁵ Pa or more, and 8.0×10⁶ Pa or less, preferably 5.0×10⁶ Pa or less, and more preferably 3.0×10⁶ Pa or less.

It is possible to control the storage elastic modulus E' at 120°C of the intermediate layer (C) within the above range by, for example, controlling the type and blending ratio of each component forming the intermediate layer (C).

In addition, in the pressure sensitive adhesive film 50 of the present embodiment, from the viewpoint of effectively suppressing glue residue on the support substrate side when the pressure sensitive adhesive film is peeled from the support substrate, the loss tangent (tan δ) at 120°C is 0.1 or less. The lower limit value of the loss tangent (tan δ) at 120°C is not particularly limited and, for example, is 0.0001 or more, preferably 0.001 or more, and more preferably 0.01 or more.

It is possible to control the loss tangent (tan δ) at 120°C of the intermediate layer (C) within the above range by, for example, controlling the type and blending ratio of each component forming the intermediate layer (C).

The resin forming the intermediate layer (C) includes a (meth)acrylic resin and a cross-linking agent having two or more cross-linkable functional groups in one molecule.

Examples of resins include (meth)acrylic resins, urethane-based resins, silicone-based resins, polyolefin-based resins, polyester-based resins, polyamide-based resins, fluorine-based resins, and styrene-diene block copolymer-based resins.

A (meth) acrylic resin is used in terms of the ease of adjusting the storage elastic modulus E' at 120°C. It may be used alone, or two or more types of resins may be blended together.

As the (meth) acrylic resin used for the intermediate layer (C), for example, it is possible to use the same resin as the (meth) acrylic pressure sensitive adhesive resin used for the pressure sensitive adhesive resin layer (A) described above.

The intermediate layer (C) further includes a cross-linking agent having two or more cross-linkable functional groups in one molecule in addition to the (meth)acrylic resin.

The cross-linking agent having two or more cross-linkable functional groups in one molecule is used to react with the functional groups of the (meth) acrylic resin and adjust the adhesive force and aggregating force.

Examples of such a cross-linking agent include epoxy-based compounds such as sorbitol polyglycidyl ether, polyglycerol polyglycidyl ether, pentaerythritol polyglycidyl ether, diglycerol polyglycidyl ether, glycerol polyglycidyl ether, neopentyl glycol diglycidyl ether, and resorcin diglycidyl ether; isocyanate-based compounds such as tetramethylene diisocyanate, hexamethylene diisocyanate, toluene diisocyanate 3 adducts of trimethylolpropane, polyisocyanate, diphenylmethane diisocyanate, and tolylene diisocyanate; aziridine-based compounds such as trimethylolpropane-tri-β-aziridinylpropionate, tetramethylolmethane-tri-β-aziridinylpropionate, N,N'-diphenylmethane-4,4'-bis(1-aziridinecarboxamide), N,N'-hexamethylene-1,6-bis(1-aziridinecarboxamide), N,N'-toluene-2,4-bis(1-aziridinecarboxamide), and trimethylolpropane-tri-β-(2-methylaziridine) propionate; tetrafunctional epoxy-based compounds such as N,N,N',N'-tetraglycidyl-m-xylenediamine and 1,3-bis(N,N'-diglycidylaminomethyl) cyclohexane; and melamine-based compounds such as hexamethoxymethylolmelamine. These may be used alone or in a combination of two or more types.

Among the above, it is preferable to include one type or two or more types selected from epoxy-based compounds, isocyanate-based compounds, and aziridine-based compounds.

From the viewpoint of adjusting the storage elastic modulus E' at 120°C and the loss tangent (tan δ) at 120°C of the intermediate layer (C) to the desired values, the content of the cross-linking agent in the intermediate layer (C) is 0.7 parts by mass or more and 10 parts by mass or less with respect to 100 parts by mass of the (meth) acrylic resin and preferably 0.7 parts by mass or more and 5 parts by mass or less.

In addition, in the pressure sensitive adhesive film 50 of the present embodiment, from the viewpoint of maintaining good adhesiveness between the intermediate layer (C) and the pressure sensitive adhesive resin layer (B) when peeling the support substrate from the pressure sensitive adhesive resin layer (B) by reducing the adhesive force of the pressure sensitive adhesive resin layer (B) by applying an external stimulus, the content of at least one type selected from the gas generating component and the heat-expandable microspheres in the intermediate layer (C) is preferably 0.1% by mass or less when the entire intermediate layer (C) is 100% by mass, more preferably 0.05% by mass or less, and even more preferably 0.01% by mass or less, and the intermediate layer (C) particularly preferably does not include at least one type selected from gas generating components and heat-expandable microspheres.

The thickness of the intermediate layer (C) is not particularly limited, but is preferably 5 µm or more and 300 µm or less, and more preferably 10 µm or more and 150 µm or less.

It is possible to form the intermediate layer (C), for example, by coating a coating solution on the pressure sensitive adhesive resin layer (A), the pressure sensitive adhesive resin layer (B), or the base material layer 10 described below.

As a method for coating the coating solution, it is possible to adopt a coating method known in the related art, for example, a roll coater method, a reverse roll coater method, a gravure roll method, a bar coating method, a comma coater method, or a die coater method. The drying conditions of the coated pressure sensitive adhesive are not particularly limited, but in general, it is preferable to perform the drying in a temperature range of 80°C to 200°C for 10 seconds to 10 minutes. More preferably, drying is performed at 80°C to 170°C for 15 seconds to 5 minutes. In order to sufficiently promote the cross-linking reaction between the cross-linking agent and the pressure sensitive adhesive, after the drying of the coating solution is completed, heating may be carried out at 40°C to 80°C for approximately 5 to 300 hours.

In addition, the pressure sensitive adhesive resin layer (A), the pressure sensitive adhesive resin layer (B), or the base material layer 10 and the intermediate layer (C) may be molded by coextrusion molding, or the film-like pressure sensitive adhesive resin layer (A), the pressure sensitive adhesive resin layer (B), or the base material layer 10 and the film-like intermediate layer (C) may be molded by laminating.

### <Base Layer>

In the pressure sensitive adhesive film 50 of the present embodiment, as shown in Fig. 2, it is possible to further provide the base material layer 10 between the pressure sensitive adhesive resin layer (A) and the pressure sensitive adhesive resin layer (B) for the purpose of further improving properties such as the handleability, mechanical properties, and heat resistance of the pressure sensitive adhesive film 50. For example, as shown in Fig. 2, the base material layer 10 may be provided between the pressure sensitive adhesive resin layer (A) and the intermediate layer (C), or may be provided between the pressure sensitive adhesive resin layer (B) and the intermediate layer (C).

The base material layer 10 is not particularly limited and examples thereof include a resin film.

It is possible to use a known thermoplastic resin as the resin forming the resin film described above. Examples thereof include one type or two or more types selected from polyolefins such as polyethylene, polypropylene, poly(4-methyl-1-pentene), and poly(1-butene); polyesters such as polyethylene terephthalate, polybutylene terephthalate, and polyethylene naphthalate; polyamides such as nylon-6, nylon-66, polymetaxylene adipamide; polyacrylates; polymethacrylates; polyvinyl chlorides; polyvinylidene chlorides; polyimides; polyetherimides; ethylene/vinyl acetate copolymers; polyacrylonitrile; polycarbonates; polystyrenes; ionomers; polysulfones; polyethersulfone; and polyphenylene ether.

Among these, from the viewpoint of an excellent balance between the transparency, mechanical strength, and price, one type or two or more types selected from polypropylene, polyethylene terephthalate, polyethylene naphthalate, polyamide, and polyimide are preferable, and at least one type selected from polyethylene terephthalate and polyethylene naphthalate is more preferable.

The base material layer 10 may be a single layer or two or more types of layers.

In addition, the form of the resin film used to form the base material layer 10 may be a stretched film or may be a film stretched in the uniaxial or biaxial direction; however, from the viewpoint of improving the mechanical strength of the base material layer 10, it is preferable to use a film stretched in the uniaxial or biaxial direction.

From the viewpoint of obtaining good film properties, the thickness of the base material layer 10 is preferably 1 µm or more and 500 µm or less, more preferably 5 µm or more and 300 µm or less, and even more preferably 10 µm or more and 250 µm or less.

The base material layer 10 may be subjected to a surface treatment in order to improve the adhesiveness to other layers. Specifically, a corona treatment, a plasma treatment, an undercoat treatment, or a primer coat treatment, may be performed.

### <Other Layers>

In the pressure sensitive adhesive film 50 of the present embodiment, for example, an adhesive layer may be further provided between the base material layer 10 and the pressure sensitive adhesive resin layer (A) or between the base material layer 10 and the pressure sensitive adhesive resin layer (B) as long as the effects of the present embodiment are not impaired.

### 2. Method for Manufacturing Electronic Device

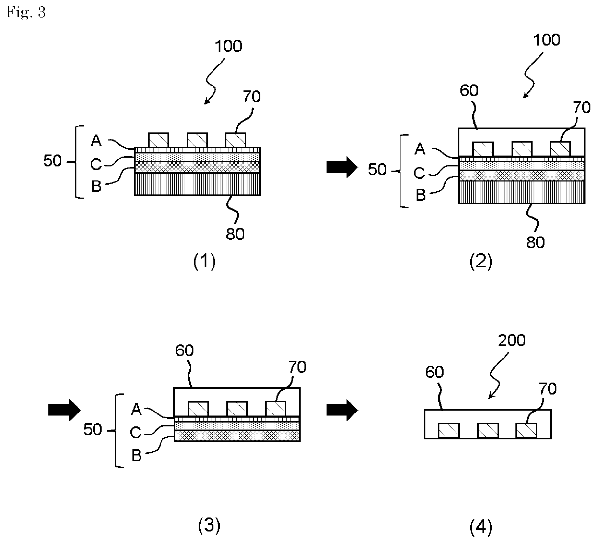

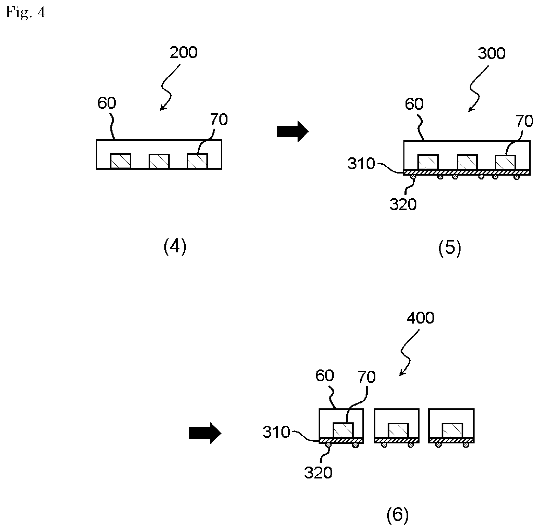

Next, a description will be given of the method for manufacturing an electronic device according to the present embodiment. Figs. 3 and 4 are cross-sectional views schematically showing an example of a method for manufacturing an electronic device of an embodiment according to the present invention.

The method for manufacturing an electronic device according to the present embodiment is provided with at least the following four steps.
(1) A step of preparing a structure 100 provided with the pressure sensitive adhesive film 50 according to the present embodiment, an electronic component 70 attached to the pressure sensitive adhesive resin layer (A) of the pressure sensitive adhesive film 50, and a support substrate 80 attached to a pressure sensitive adhesive resin layer (B) of the pressure sensitive adhesive film 50
(2) A step of sealing the electronic component 70 with a sealing material 60
(3) A step of peeling the support substrate 80 from the structure 100 by decreasing the adhesive force of the pressure sensitive adhesive resin layer (B) by applying an external stimulus
(4) A step of peeling the pressure sensitive adhesive film 50 from the electronic component 70

Then, in the method for manufacturing the electronic device according to the present embodiment, the pressure sensitive adhesive film 50 according to the present embodiment described above is used as the pressure sensitive adhesive film for temporarily fixing the electronic component 70.

A description will be given below of each step of the method for manufacturing an electronic device according to the present embodiment.

### (Step (1))

First, the structure 100 is prepared, which is provided with the pressure sensitive adhesive film 50, the electronic component 70 attached to the pressure sensitive adhesive resin layer (A) of the pressure sensitive adhesive film 50, and the support substrate 80 attached to the pressure sensitive adhesive resin layer (B) of the pressure sensitive adhesive film 50.

It is possible to manufacture the structure 100, for example, by the following procedure.

First, the pressure sensitive adhesive film 50 is attached onto the support substrate 80 such that the pressure sensitive adhesive resin layer (B) is on the support substrate 80 side. A protective film may be attached on the pressure sensitive adhesive resin layer (B) and it is possible to peel off the protective film and to attach the exposed surface of the pressure sensitive adhesive resin layer (B) to the surface of the support substrate 80.

As the support substrate 80, for example, it is possible to use a quartz substrate, a glass substrate, or a SUS substrate.

Next, it is possible to obtain the structure 100 by arranging the electronic component 70 on the pressure sensitive adhesive resin layer (A) of the pressure sensitive adhesive film 50 attached on the support substrate 80.

Examples of the electronic component 70 include a semiconductor chip such as an IC, an LSI, a discrete component, a light emitting diode, a light receiving element, a semiconductor panel, and a semiconductor package.

### (Step (2))

Next, the electronic component 70 is sealed with the sealing material 60.

The electronic component 70 is covered with the sealing material 60, and the electronic component 70 is sealed by curing the sealing material 60 at a temperature of 150°C or lower, for example.

In addition, the form of the sealing material 60 is not particularly limited, but is, for example, a granular form, a sheet form, or a liquid form.

The sealing material 60 is not particularly limited, but, for example, it is possible to use an epoxy resin-based sealing material using an epoxy resin.

In particular, a liquid epoxy resin-based sealing material is preferable from the viewpoint of improving the affinity of the sealing material 60 with the pressure sensitive adhesive film 50 and being able to more evenly seal the electronic component 70. As such an epoxy resin-based sealing material, for example, it is possible to use the T693/R4000 series, T693/R1000 series, and T693/R5000 series manufactured by Nagase Chemtex Corp.

Examples of the sealing method include transfer molding, injection molding, compression molding, and cast molding. After sealing the electronic component 70 with the sealing material 60, for example, the sealing material 60 is cured by heating at a temperature of 150°C or lower and the structure 100 in which the electronic component 70 is sealed is obtained.

### (Step (3))

Next, the adhesive force of the pressure sensitive adhesive resin layer (B) is decreased by applying an external stimulus and the support substrate 80 is peeled from the structure 100.

It is possible to easily remove the support substrate 80 from the pressure sensitive adhesive film 50 by, for example, sealing the electronic component 70 and then heating at a temperature over 150°C to decrease the adhesive force of the pressure sensitive adhesive resin layer (B).

### (Step (4))

Next, the pressure sensitive adhesive film 50 is removed from the electronic component 70 to obtain an electronic device 200.

Examples of a method for removing the pressure sensitive adhesive film 50 from the electronic component 70 include a mechanical peeling method and a method for decreasing the adhesive force of the surface of the pressure sensitive adhesive film 50 and then peeling the pressure sensitive adhesive film 50.

### (Step (5))

As shown in Fig. 4, the method for manufacturing an electronic device according to the present embodiment may be further provided with a step (5) of forming a wiring layer 310 and bumps 320 on an exposed surface of the obtained electronic device 200 to obtain an electronic device 300.

The wiring layer 310 is provided with a pad (not shown), which is an external connection terminal formed on the outermost surface, and wiring (not shown), which electrically connects the exposed electronic component 70 and the pad. It is possible to form the wiring layer 310 by a method known in the related art and the structure thereof may be multi-layer.

Then, it is possible to obtain the electronic device 300 by forming the bumps 320 on the pad of the wiring layer 310. Examples of the bumps 320 include solder bumps and gold bumps. It is possible to form the solder bumps, for example, by arranging a solder ball on the pad which is the external connection terminal of the wiring layer 310 and carrying out heating to melt (reflow) the solder.

It is possible to form gold bumps by methods such as a ball bonding method, a plating method, or an Au ball transfer method.

### (Step (6))

The method for manufacturing an electronic device according to the present embodiment may be further provided with a step (6) of dicing the electronic device 300 to obtain a plurality of electronic devices 400, as shown in Fig. 4.

It is possible to perform the dicing of the electronic device 300 by a known method.

### [Examples]

A specific description will be given below of the present invention with reference to Examples, but the present invention is not limited thereto.

Details of the materials used to manufacture the pressure sensitive adhesive film in Examples and Comparative Examples are as follows.

### <Pressure Sensitive Adhesive Coating Solution A for Forming Pressure Sensitive Adhesive Resin Layer (A)>

### (Preparation of Pressure Sensitive Adhesive Resin Solution A1)

Into deionized pure water, 0.5 parts by mass of 4,4'-azobis-4-cyanovaleric acid (manufactured by Otsuka Chemical Co., Ltd., trade name: ACVA) as a polymerization initiator, 74.3 parts by mass of acrylic acid-n-butyl and 13.7 parts by mass of methyl methacrylate as the monomer (A), 9 parts by mass of 2-hydroxyethyl methacrylate as the monomer (B), and 3 parts by mass of a polymerizable surfactant in which a polymerizable 1-propenyl group was introduced into a benzene ring of ammonium salt of sulfuric acid ester of polyoxyethylene nonylphenyl ether (manufactured by Daiichi Kogyo Seiyaku Co., Ltd.; trade name: Aqualon HS-1025) were each added. Next, emulsion polymerization was carried out for 8 hours at 70°C to 72°C while stirring to obtain an acrylic-based resin emulsion. The result was neutralized with aqueous ammonia (pH = 7.0) to obtain a pressure sensitive adhesive resin solution A1 having a solid content concentration of 42.5%.

### (Preparation of Pressure Sensitive Adhesive Resin Solution A2)

Into deionized pure water, 0.5 parts by mass of ammonium persulfate as a polymerization initiator, 63 parts by mass of 2-ethylhexyl acrylate, 21 parts by mass of acrylic acid-n-butyl, and 9 parts by mass of methyl methacrylate as the monomer (A), 3 parts by mass of 2-hydroxyethyl methacrylate as the monomer (B), 1 part by mass of polytetramethylene glycol diacrylate (manufactured by NOF Corp., trade name ADT-250) as a monomer (C), and 2 parts by mass of a polymerizable surfactant in which a polymerizable 1-propenyl group was introduced into a benzene ring of an ammonium salt of a sulfuric acid ester of polyoxyethylene nonylphenyl ether (manufactured by Daiichi Kogyo Seiyaku Co., Ltd.; trade name: Aqualon HS-1025) were each added, and emulsion polymerization was carried out for 8 hours at 70°C to 72°C while stirring to obtain an acrylic-based resin emulsion. The result was neutralized with aqueous ammonia (pH = 7.0) to obtain a pressure sensitive adhesive resin solution A2 having a solid content concentration of 56.5%.

### (Preparation of Pressure Sensitive Adhesive Coating Solution A)

50 parts by mass of pressure sensitive adhesive resin solution A1, 50 parts by mass of pressure sensitive adhesive resin solution A2, 0.3 parts by mass of dimethylethanolamine, and 6 parts by mass of an epoxy-based compound (Ex-1610, manufactured by Nagase Chemtex Corp.) as a cross-linking agent were mixed together to obtain a pressure sensitive adhesive coating solution A.

### <Pressure Sensitive Adhesive Coating Solution B for Forming Pressure Sensitive Adhesive Resin Layer (B)>

### (Preparation of Polymer A Solution)

74 parts by mass of acrylic acid-n-butyl, 16 parts by mass of methyl methacrylate, 7 parts by mass of 2-hydroxyethyl methacrylate, and 3 parts by mass of acrylic acid were copolymerized in a mixed solvent of toluene and ethyl acetate, and a polymer A solution having a concentration of 45% by mass and a molecular weight of 250,000 was obtained.

### (Preparation of Pressure Sensitive Adhesive Coating Solution B)

The polymer A solution, an isocyanate-based compound (Mitsui Chemicals Inc., Olestar P49-75S) as a cross-linking agent, heat-expandable microspheres with an expansion start temperature of 160°C, and a tackifier (Arakawa Chemical Industries, Ltd., Pensel D-125) were mixed at a ratio of 100: 2: 15: 5 (solid content mass ratio) to obtain a pressure sensitive adhesive coating solution B.

### <Coating Solution C for Forming Intermediate Layer (C)>

### (Preparation of Polymer A Solution)

74 parts by mass of acrylic acid-n-butyl, 16 parts by mass of methyl methacrylate, 7 parts by mass of 2-hydroxyethyl methacrylate, and 3 parts by mass of acrylic acid were copolymerized in a mixed solvent of toluene and ethyl acetate, and a polymer A solution having a concentration of 45% by mass and a molecular weight of 250,000 was obtained.

### (Preparation of Polymer B Solution)

35 parts by mass of 2-ethylhexyl acrylate, 41 parts by mass of acrylic acid-n-butyl, 15 parts by mass of ethyl acrylate, and 9 parts by mass of 2-hydroxyethyl methacrylate were copolymerized under a nitrogen atmosphere in a mixed solvent of toluene and ethyl acetate to obtain a polymer B solution having a molecular weight of 300,000.

### (Preparation of Coating Solution C)

The polymer A solution and an epoxy-based compound (Tetrad C, manufactured by Mitsubishi Gas Chemical Company, Inc.) as a cross-linking agent were mixed at a ratio of 100: 1 (solid content mass ratio) to obtain a coating solution C1.

In addition, the coating solutions C1 to C9 were each prepared in the same manner as the coating solution C1 except that the type of the polymer solution, the type of the cross-linking agent and the blending amount were changed to the values shown in Table 1.

The epoxy-based compound in Table 1 is Tetrad C (manufactured by Mitsubishi Gas Chemical Company, Inc.) and the isocyanate-based compound is Olestar P49-75S (manufactured by Mitsui Chemicals Inc.) .

### [Example 1]

The pressure sensitive adhesive coating solution A was coated onto a polyethylene terephthalate (PET) film (thickness 38 µm), which was a base material layer, and then dried to form a pressure sensitive adhesive resin layer (A) having a thickness of 13 µm. Next, the coating solution C1 was coated on the surface of the PET film on the opposite side to the pressure sensitive adhesive resin layer (A) and then dried to form an intermediate layer (C) having a thickness of 20 µm. Next, the pressure sensitive adhesive coating solution B was coated onto the intermediate layer (C) and then dried to form a pressure sensitive adhesive resin layer (B) having a thickness of 25 µm and obtain a pressure sensitive adhesive film.

The following evaluation was performed on the obtained pressure sensitive adhesive film. The obtained results are shown in Table 1.

### [Examples 2 to 6 and Comparative Examples 1 to 3]

Pressure sensitive adhesive films were each produced in the same manner as in Example 1 except that the coating solutions C2 to C9 were used instead of the coating solution C1.

The following evaluations were performed on the obtained pressure sensitive adhesive films. The obtained results are each shown in Table 1.

### [Comparative Example 4]

A pressure sensitive adhesive film was produced in the same manner as in Example 1 except that the intermediate layer (C) was not formed.

The following evaluations were performed on the obtained pressure sensitive adhesive films. The obtained results are each shown in Table 1.

### <Evaluation>

### (1) Measurement of Storage Elastic Modulus E' and Loss Tangent (tan δ) at 120°C of Intermediate Layer (C)

Coating solutions C1 to C9 were each coated on the release film such that the dry thickness was 20 µm and then dried in an oven at 110°C for 3 minutes. Next, the samples for viscoelasticity measurement were obtained by overlapping samples on each other until the sample thickness became 1 mm.

Next, using a solid-state viscoelasticity measurement apparatus (RSA-3, TA Instruments), the solid-state viscoelasticity of the intermediate layer (C) was measured under conditions of a frequency of 1 Hz, a temperature rise rate of 5°C/min, a strain of 0.05%, a distance between chucks of 20 mm, and a sample width of 10 mm, and the storage elastic modulus E' and loss tangent (tan δ) at 120°C of the intermediate layer (C) were calculated, respectively.

### (2) Glue Residue on Support Substrate

The pressure sensitive adhesive resin layers (B) of the pressure sensitive adhesive films obtained in the Examples and Comparative Examples were attached to a support substrate and then a plurality of silicon chips were placed on the pressure sensitive adhesive resin layer (A).

Next, after being left to stand at 23°C for 1 minute, the plurality of silicon chips arranged on the pressure sensitive adhesive resin layer (A) were sealed using a compression molding machine (WCM-300MC from Apic Yamada Corporation) for 3 minutes at a temperature of 120°C using a liquid epoxy resin-based sealing material (T693/R4212 manufactured by Nagase Chemtex Corp.).

Next, the structure of the support substrate/pressure sensitive adhesive film/silicon chip/sealing material was removed from the compression molding machine and heated in an oven at 150°C for 30 minutes and then the pressure sensitive adhesive resin layer (B) was foamed at 185°C to detach the support substrate from the structure of the pressure sensitive adhesive film/silicon chip/sealing material.

Next, the surface of the support substrate after detachment was visually observed to confirm pressure sensitive adhesive film glue residue on the surface of the support substrate, and the pressure sensitive adhesive film glue residue was evaluated according to the following criteria.

O: No glue residue was observed on the surface of the support substrate by visual inspection.

X: Glue residue was observed on the surface of the support substrate by visual inspection.

**Table 1**

| | | | **Example 1** | **Example 2** | **Example 3** | **Example 4** | **Example 5** | **Example 6** | **Comparative Example 1** | **Comparative Example 2** | **Comparative Example 3** | **Comparative Example 4** |
|---|---|---|---|---|---|---|---|---|---|---|---|---|
| **Coating solution C** | **Coating solution** | | **C1** | **C2** | **C3** | **C4** | **C5** | **C6** | **C7** | **C8** | **C9** | **-** |
| | **Polymer** | **Type** | **Polymer A** | **Polymer A** | **Polymer A** | **Polymer A** | **Polymer B** | **Polymer B** | **Polymer A** | **Polymer A** | **Polymer B** | |
| | | **Parts by mass** | **100** | **100** | **100** | **100** | **100** | **100** | **100** | **100** | **100** | |
| | **Cross-linking agent** | **Type** | **Epoxy-based compound** | **Epoxy-based compound** | **Epoxy-based compound** | **Isocyanate based compound** | **Isocyanate based compound** | **Isocyanate - based compound** | **Isocyanate based compound** | **Isocyanate based compound** | **Isocyanate-based compound** | |
| | | **Parts by mass** | **1** | **2** | **3** | **2** | **1** | **2** | **0.5** | **0.3** | **0.5** | |
| **Evaluation** | **E' at 120°C [Pa]** | | **7.5E + 05** | **1.5E + 06** | **2.6E + 06** | **3.BE + 05** | **1.8E + 05** | **2.6E + 05** | **1.1E + 05** | **6.3E + 04** | **5.9E + 04** | **-** |
| | **tan δ at 120°C** | | **0.013** | **0.006** | **0.003** | **0.041** | **0.097** | **0.061** | **0.239** | **0.425** | **0.356** | **-** |
| | **Glue residue** | | **○** | **○** | **○** | **○** | **○** | **○** | **○** | **x** | **x** | **x** |

In Examples 1 to 6 using a pressure sensitive adhesive film, in which the storage elastic modulus E' at 120°C of the intermediate layer (C) was 1.0×10⁵ Pa or more and 8.0×10⁶ Pa or less and the loss tangent (tan δ) at 120°C of the intermediate layer (C) was 0.1 or less, no glue residue was observed on the support substrate. Therefore, in the pressure sensitive adhesive films of Examples 1 to 6, it is understood that it is possible to suppress glue residue on the support substrate side when the pressure sensitive adhesive film is peeled from the support substrate.

On the other hand, in Comparative Examples 2 and 3 using a pressure sensitive adhesive film, in which the storage elastic modulus E' at 120°C of the intermediate layer (C) was less than 1.0x10⁵ Pa and the loss tangent (tan δ) was greater than 0.1, Comparative Example 1 using a pressure sensitive adhesive film, in which the loss tangent (tan δ) at 120°C of the intermediate layer (C) was greater than 0.1, or Comparative Example 4 which used a pressure sensitive adhesive film which was not provided with an intermediate layer (C), glue residue was observed on the support substrate. Thus, it is understood that, in the pressure sensitive adhesive films of Comparative Examples 1 to 4, glue residue is generated on the support substrate side when the pressure sensitive adhesive film is peeled from the support substrate.

## Claims

1. Use of a pressure sensitive adhesive film for temporarily fixing electronic components when sealing the electronic components with a sealing material in an electronic device manufacturing step, the film comprising:
a pressure sensitive adhesive resin layer (A) used for temporarily fixing the electronic components;
a pressure sensitive adhesive resin layer (B) used for attaching to a support substrate and of which an adhesive force is decreased by heating or radiation as an external stimulus; and
an intermediate layer (C) provided between the pressure sensitive adhesive resin layer (A) and the pressure sensitive adhesive resin layer (B),
wherein a storage elastic modulus E' at 120°C of the intermediate layer (C) is 1.0 x 10⁵ Pa or more and 8.0 x 10⁶ Pa or less, and a loss tangent (tan δ) at 120°C of the intermediate layer (C) is 0.1 or less, the storage elastic modulus E' at 120°C and the loss tangent (tan δ) at 120°C being determined as described in the section "Measurement of Storage Elastic Modulus E' and Loss Tangent (tan δ) at 120°C of Intermediate Layer (C)" of the description, and
the intermediate layer (C) includes a (meth)acrylic resin and a cross-linking agent having two or more cross-linkable functional groups in one molecule, and the content of the cross-linking agent in the intermediate layer (C) is 0.7 parts by mass or more and 10 parts by mass or less with respect to 100 parts by mass of the (meth)acrylic resin.

2. The use according to claim 1,
wherein the adhesive force of the pressure sensitive adhesive resin layer (B) is decreased by heating.

3. The use according to claim 2,
wherein the pressure sensitive adhesive resin layer (B) is a heat-peelable pressure sensitive adhesive resin layer, which includes at least one selected from a gas generating component and heat-expandable microspheres.

4. The use according to any one of claims 1 to 3,
wherein a content of at least one selected from a gas generating component and heat-expandable microspheres in the pressure sensitive adhesive resin layer (A) is 0.1% by mass or less when the entire pressure sensitive adhesive resin layer (A) is defined as 100% by mass.

5. The use according to any one of claims 1 to 4,
wherein the sealing material is an epoxy resin-based sealing material.

6. The use according to any one of claims 1 to 5,
wherein the pressure sensitive adhesive resin layer (A) includes a (meth)acrylic pressure sensitive adhesive resin.

7. A method for manufacturing an electronic device comprising at least:
a step (1) of preparing a structure having the pressure sensitive adhesive film as defined in any one of claims 1 to 6, an electronic component attached to the pressure sensitive adhesive resin layer (A) of the pressure sensitive adhesive film, and a support substrate attached to the pressure sensitive adhesive resin layer (B) of the pressure sensitive adhesive film;
a step (2) of sealing the electronic component with a sealing material;
a step (3) of peeling the support substrate from the structure by decreasing an adhesive force of the pressure sensitive adhesive resin layer (B) by applying the external stimulus; and
a step (4) of peeling the pressure sensitive adhesive film from the electronic component.

8. The method for manufacturing an electronic device according to claim 7, wherein the sealing material is an epoxy resin-based sealing material.

## Patentansprüche

1. Verwendung eines Haftklebstofffilms zum temporären Fixieren von elektronischen Komponenten beim Abdichten der elektronischen Komponenten mit einem Dichtungsmaterial in einem Herstellungsschritt einer elektronischen Vorrichtung, wobei der Film umfasst:
eine Haftklebstoffharzschicht (A), die zum temporären Fixieren der elektronischen Komponenten verwendet wird;
eine Haftklebstoffharzschicht (B), die zum Anbringen an einem Trägersubstrat verwendet wird und deren Haftkraft durch Erwärmen oder Strahlung als äußerer Stimulus verringert wird; und
eine Zwischenschicht (C), die zwischen der Haftklebstoffharzschicht (A) und der Haftklebstoffharzschicht (B) angeordnet ist,
wobei ein Speicherelastizitätsmodul E' bei 120°C der Zwischenschicht (C) 1,0 x 10⁵ Pa oder mehr und 8,0 x 10⁶ Pa oder weniger beträgt und ein Verlustfaktor (tan δ) bei 120°C der Zwischenschicht (C) 0,1 oder weniger beträgt, wobei der Speicherelastizitätsmodul E' bei 120°C und der Verlustfaktor (tan δ) bei 120°C wie in dem Abschnitt "Measurement of Storage Elastic Modulus E' and Loss Tangent (tan δ) at 120°C of Intermediate Layer (C)" der Beschreibung bestimmt werden, und
die Zwischenschicht (C) ein (Meth)acrylharz und ein Vernetzungsmittel mit zwei oder mehr vernetzbaren funktionellen Gruppen in einem Molekül enthält und der Gehalt des Vernetzungsmittels in der Zwischenschicht (C) 0,7 Masseteile oder mehr und 10 Masseteile oder weniger, bezogen auf 100 Masseteile des (Meth)acrylharzes, beträgt.

2. Verwendung gemäß Anspruch 1,
wobei die Haftkraft der Haftklebstoffharzschicht (B) durch Erwärmen verringert wird.

3. Verwendung gemäß Anspruch 2,
wobei die Haftklebstoffharzschicht (B) eine wärmeablösbare Haftklebstoffharzschicht ist, die mindestens eines, ausgewählt aus einer gaserzeugenden Komponente und wärmeexpandierbaren Mikrosphären, enthält.

4. Verwendung gemäß einem der Ansprüche 1 bis 3,
wobei ein Gehalt von dem mindestens einem, ausgewählt aus einer gaserzeugenden Komponente und wärmeexpandierbaren Mikrosphären, in der Haftklebstoffharzschicht (A) 0,1 Massen-% oder weniger beträgt, wenn die gesamte Haftklebstoffharzschicht (A) als 100 Massen-% definiert wird.

5. Verwendung gemäß einem der Ansprüche 1 bis 4,
wobei das Dichtungsmaterial ein Dichtungsmaterial auf Epoxidharzbasis ist.

6. Verwendung gemäß einem der Ansprüche 1 bis 5,
wobei die Haftklebstoffharzschicht (A) ein (Meth)acryl-Haftklebstoffharz enthält.

7. Verfahren zur Herstellung einer elektronischen Vorrichtung, mindestens umfassend:
einen Schritt (1) des Herstellens einer Struktur mit dem Haftklebstofffilm, wie in einem der Ansprüche 1 bis 6 definiert, einer an der Haftklebstoffharzschicht (A) des Haftklebstofffilms befestigten elektronischen Komponente und einem an der Haftklebstoffharzschicht (B) des Haftklebstofffilms befestigten Trägersubstrat;
einen Schritt (2) des Abdichtens der elektronischen Komponente mit einem Dichtungsmaterial;
einen Schritt (3) des Ablösens des Trägersubstrats von der Struktur durch Verringern der Haftkraft der Haftklebstoffharzschicht (B) durch Anwenden eines äußeren Stimulus; und
einen Schritt (4) des Ablösens des Haftklebstofffilms von der elektronischen Komponente.

8. Verfahren zur Herstellung einer elektronischen Vorrichtung gemäß Anspruch 7, wobei das Dichtungsmaterial ein Dichtungsmaterial auf Epoxidharzbasis ist.

## Revendications

1. Utilisation d'un film autocollant sensible à la pression pour fixer temporairement des composants électroniques lors de l'étanchéification des composants électroniques avec un matériau d'étanchéité dans une étape de fabrication de dispositif électronique, le film comprenant :
une couche de résine autocollante sensible à la pression (A) utilisée pour fixer temporairement les composants électroniques ;
une couche de résine autocollante sensible à la pression (B) utilisée pour se fixer à un substrat de support et dont une force d'adhérence est diminuée par chauffage ou rayonnement sous la forme d'un stimulus externe ; et
une couche intermédiaire (C) prévue entre la couche de résine autocollante sensible à la pression (A) et la couche de résine autocollante sensible à la pression (B),
dans laquelle un module d'élasticité de stockage E' à 120°C de la couche intermédiaire (C) est supérieur ou égal à 1,0 x 10⁵ Pa et inférieur ou égal à 8,0 x 10⁶ Pa, et une tangente de perte (tan δ) à 120°C de la couche intermédiaire (C) est inférieure ou égale à 0,1, le module d'élasticité de stockage E' à 120°C et la tangente de perte (tan δ) à 120°C étant déterminés comme décrit dans la section « Mesure du module d'élasticité de stockage E' et de la tangente de perte (tan δ) à 120°C de la couche intermédiaire (C) » de la description, et
la couche intermédiaire (C) inclut une résine (méth)acrylique et un agent de réticulation présentant deux groupes fonctionnels réticulables ou plus dans une molécule, et la teneur en agent de réticulation dans la couche intermédiaire (C) est supérieure ou égale à 0,7 parties en masse et inférieure ou égale à 10 parties par rapport à 100 parties en masse de la résine (méth)acrylique.

2. Utilisation selon la revendication 1,
dans laquelle la force d'adhérence de la couche de résine autocollante sensible à la pression (B) est diminuée par chauffage.

3. Utilisation selon la revendication 2,
dans laquelle la couche de résine autocollante sensible à la pression (B) est une couche de résine autocollante sensible à la pression pelable à chaud, qui inclut au moins un élément sélectionné parmi un composant générant du gaz et des microsphères thermoexpansibles.

4. Utilisation selon l'une quelconque des revendications 1 à 3,
dans laquelle une teneur en au moins un élément sélectionné parmi un composant générant du gaz et des microsphères thermoexpansibles dans la couche de résine autocollante sensible à la pression (A) est inférieure ou égale à 0,1 % en masse lorsque toute la couche de résine autocollante sensible à la pression (A) est définie comme 100 % en masse.

5. Utilisation selon l'une quelconque des revendications 1 à 4,
dans laquelle le matériau d'étanchéité est un matériau d'étanchéité à base de résine époxy.

6. Utilisation selon l'une quelconque des revendications 1 à 5,
dans laquelle la couche de résine autocollante sensible à la pression (A) inclut une résine autocollante sensible à la pression (méth)acrylique.

7. Procédé de fabrication d'un dispositif électronique comprenant au moins :
une étape (1) de préparation d'une structure présentant le film autocollant sensible à la pression comme défini selon l'une quelconque des revendications 1 à 6, un composant électronique fixé à la couche de résine autocollante sensible à la pression (A) du film autocollant sensible à la pression, et un substrat de support fixé à la couche de résine autocollante sensible à la pression (B) du film autocollant sensible à la pression ;
une étape (2) d'étanchéification du composant électronique avec un matériau d'étanchéité ;
une étape (3) de pelage du substrat de support à partir de la structure en diminuant une force d'adhérence de la couche de résine autocollante sensible à la pression (B) en appliquant le stimulus externe ; et
une étape (4) de pelage du film autocollant sensible à la pression à partir du composant électronique.

8. Procédé de fabrication d'un dispositif électronique selon la revendication 7, dans lequel le matériau d'étanchéité est un matériau d'étanchéité à base de résine époxy.
